# EUROPEAN PATENT APPLICATION

(11) **EP 2 728 635 A1**
(43) Date of publication of application: **07.05.2014**
(21) Application number: 11868480.2
(22) Date of filing: 30.06.2011
(51) Int. Cl.: H01L 51/50

(54) **TOP-EMITTING ORGANIC LIGHT-EMITTING DEVICE AND METHOD FOR PREPARING THE SAME**

(71) Applicant: Ocean's King Lighting Science&Technology Co., Ltd., Guangdong 518054 (CN)
(72) Inventor: ZHOU, Mingjie, Shenzhen Guangdong 518054 (CN); WANG, Ping, Shenzhen Guangdong 518054 (CN); HUANG, Hui, Shenzhen Guangdong 518054 (CN)
(74) Representative: Lenthall, Joseph
(86) International application number: PCT/CN2011/076704
(87) International publication number: WO 2013/000162

(57) **Abstract**

A top-emitting organic light-emitting device (OLED) and a method for preparing the same are provided. The top-emitting organic light-emitting device comprises, stacked in sequence, a substrate (101), an anode layer (102), a self-assembled modification monolayer (103), a hole-transport layer (104), a light-emitting layer (105), an electron-transport layer (106), an electron-injection layer (107) and a cathode layer (108). The self-assembled modification monolayer (103) is formed of alkanethiol having a general formula CH₃(CH₂)ₙ-SH. Utilizing the self-assembled modification monolayer (103), the work-function of the anode layer (102) is increased, the hole-injection barrier between the anode layer (102) and the hole-transport layer (104) is reduced, the start-voltage of the OLED is decreased, and the luminous efficiency of the OLED is improved.

## Description

### FIELD OF THE INVENTION

The present invention relates to the field of optoelectronic devices, and particularly relates to a top-emitting organic light-emitting device. The present invention also relates to a method for preparing the top-emitting organic light-emitting device.

### BACKGROUND OF THE INVENTION

Organic light-emitting device (also known as Organic Light Emission Diode), hereinafter referred to as OLED, has characteristics such as high luminance, wide selection of material, low driving voltage and solid-state self-luminosity, as well as advantages such as high definition, wide viewing angle and fast response, which makes it not only conform to the development trends of mobile communication and information display in the information age, but also meet the requirements of green lighting technology. OLED is the primary focus of many domestic and overseas researchers.

The OLED device in the prior art using flexible material as substrate has advantages of thinner and more impact-resistant over OLED device having glass substrate. Also, flexible OLED can be manufactured by roll-to-roll method, thereby significantly reducing the manufacturing cost. Usually, the anode using polymer film as substrate is manufactured by sputtering technique to cover a transparent conductive thin film, ITO or IZO for instance, on its surface. However, in the process of manufacturing ITO thin film, the doping proportion of various elements, such as indium (In) and stannum (Sn), is difficult to control, resulting in uncontrollable morphology of ITO, and uncontrollable carrier transmission performance. Secondly, when conductive thin film such as ITO is manufactured on flexible substrate, low-temperature sputtering technique is usually adopted. The conductive thin film as prepared has high surface resistance, weak bonding force between the thin film and the substrate, so that the conductive thin film is prone to fall off the substrate in the process of repeated bending of flexible OLED, thus affecting the stability of the OLED device.

Some metal material such as aluminum (Al), silver (Ag) can form a film with good conductivity and high reflectivity on polymer film by vapor deposition process. After formation of the film on polymer film, adhesion with substrate is superior to ITO conductive film, so it is suitable for production of anode of the top-emitting OLED device. But there is a large potential barrier between the HOMO orbital of the metal material (such as Al, Ag) and the hole-transport material (e.g., NPB, TPD), the hole injecting ability of anode is degraded, thus affecting the luminous efficiency of the OLED.

### SUMMARY OF THE INVENTION

The purpose of the present invention is to provide a top-emitting organic light-emitting device having a high luminous efficiency.

A top-emitting organic light-emitting device, comprising a substrate, an anode layer, a self-assembled modification monolayer, a hole-transport layer, a light-emitting layer, an electron-transport layer, an electron-injection layer and a cathode layer stacked in sequence.

In the top-emitting organic light-emitting device, material of the self-assembled modification monolayer is alkanethiol, which has a general formula of CH₃(CH₂)ₙ-SH, wherein, 5≤n≤21. The self-assembled modification monolayer links to metallic film by chemical bonds via sulfhydryl group of thiol.

In the top-emitting organic light-emitting device of the present invention, material of the substrate is polymer thin film, such as polyethylene terephthalate (PET), polyether sulfone (PES), polyethylene naphthalate (PEN) or polycarbonate (PC).

Cathode layer of the top-emitting organic light-emitting device is one monolayer or two stacked monolayers; material of said cathode layer is aluminium, silver, samarium or ytterbium.

In the top-emitting organic light-emitting device, material of organic functional layers is selected as follows:

Material of hole-transport layer is selected from the group consisting of N,N'-di-[(1-naphthalenyl)-N,N'-diphenyl]- (1,1'-biphenyl)- 4,4'- diamine (NPB), N,N'-bis(3-methylphenyl)-N,N'-diphenyl-benzidine (TPD) and 1,1-bis[4-(N,N-di(p-tolyl)amino)phenyl]cyclohexane (TAPC);

Material of light-emitting layer is selected from N,N'-di-[(1-naphthalenyl)-N,N'-diphenyl]- (1,1'-biphenyl)- 4,4'- diamine (NPB) doped with bis(2-methyldibenzo[f,h]quinoxaline) (acetylacetonate) iridium (Ir(MDQ)₂(acac)), 4,4',4"-tris(carbazol-9-yl)-triphenylamine (TCTA) doped with tris(2-phenylpyridine) iridium (Ir(ppy)₃), tris(8-hydroxyquinolinato)aluminium (Alq₃) doped with 4-(dicyanomethylene)-2-tert-butyl-6-(1,1,7,7-tetramethyljulolidin-4-yl-vinyl)-4h-pyra n (DCJTB), and DPVBi; that is, materials of light-emitting layer are selected from NPB:Ir(MDQ)₂(acac) (wherein, NPB is host material, Ir(MDQ)₂(acac) is guest material, doping mass percentage of the guest material is 5%), TCTA:Ir(ppy)₃ (wherein, TCTA is host material, Ir(ppy)₃ is guest material, doping mass percentage of the guest material is 3%), Alq₃: DCJTB (wherein, Alq₃ is host material, DCJTB is guest material, doping mass percentage of the guest material is 2%) and DPVBi.

Material of electron-transport layer is selected from the group consisting of tris(8-hydroxyquinolinato)aluminium (Alq₃), 4,7-diphenyl-1,10-phenanthroline (Bphen) and 1,3,5-tris(1-phenyl-1H-benzimidazol-2-yl)benzene (TPBi);

Material of electron-injection layer is selected from the group consisting of LiF, CsF and Li₂O.

Material of said anode layer is selected from Ag, Al, Au and other metals.

The present invention also provides a method for preparing the top-emitting organic light-emitting device, which comprises the following steps:

S1, washing and drying substrate for later use;

S2, vapor depositing an anode layer on the surface of said substrate by vacuum coating method;

S3, preparing a self-assembled modification monolayer on the surface of said anode layer;

S4, vapor depositing stacked hole-transport layer, light-emitting layer, electron-transport layer, electron-injection layer on the surface of said self-assembled modification monolayer in sequence by vacuum coating method;

S5, vapor depositing cathode layer on the surface of electron-injection layer;

After the above process, top-emitting organic light-emitting device is obtained.

In order to improve adsorption capacity of self-assembled monolayer on anode layer, step S2 of the method for preparing top-emitting organic light-emitting device further comprises the following steps:

Placing the prepared anode layer into plasma processor, vacuumizing to 10-60 Pa, discharging at high-frequency in air atmosphere, glow discharge treating under the conditions of RF power 60W for 5-15 minutes, and cleaning the surface of anode layer with plasma

By such plasma treatment, the surface energy of the anode layer is improved, thereby improving the uniformity and compactness of the self-assembled monolayer on the surface of the anode layer.

The step S3 further comprises:

S31. dissolving alkanethiol having a general formula of CH₃(CH₂)ₙ-SH into ethanol or diethyl ether to prepare solution, the molar concentration of the solution can be in the range of 0.1-10 mM;

S32. immersing the substrate on which the anode layer has been deposited into said solution, immersing for 5-30 min, taking out and drying with nitrogen flow, then obtaining the self-assembled modification monolayer on the surface of anode layer.

The top-emitting organic light-emitting device provided in the present invention comprises a self-assembled modification monolayer deposited on the surface of anode layer. Utilizing the self-assembled modification monolayer, the work-function of the anode layer is increased, the hole-injection barrier between the anode layer and the hole-transport layer is reduced, and the start-voltage of the OLED is decreased, thus improving the luminous efficiency of the OLED.

### BRIEF DESCRIPTION OF THE DRAWINGS

Fig. 1 is a structural view of the top-emitting organic light-emitting device of one embodiment; wherein,
   101 substrate, 102 anode layer, 103 self-assembled modification monolayer, 104 hole-transport layer, 105 light-emitting layer, 106 electron-transport layer, 107 electron-injection layer, 108 cathode layer;
Fig. 2 is a flow diagram showing the preparation of the top-emitting organic light-emitting device of one embodiment;
Fig. 3 shows voltage-luminance curves of the top-emitting organic light-emitting devices prepared in Example 2 and Comparative Example 1.

### DETAILED DESCRIPTION OF ILLUSTRATED EMBODIMENTS

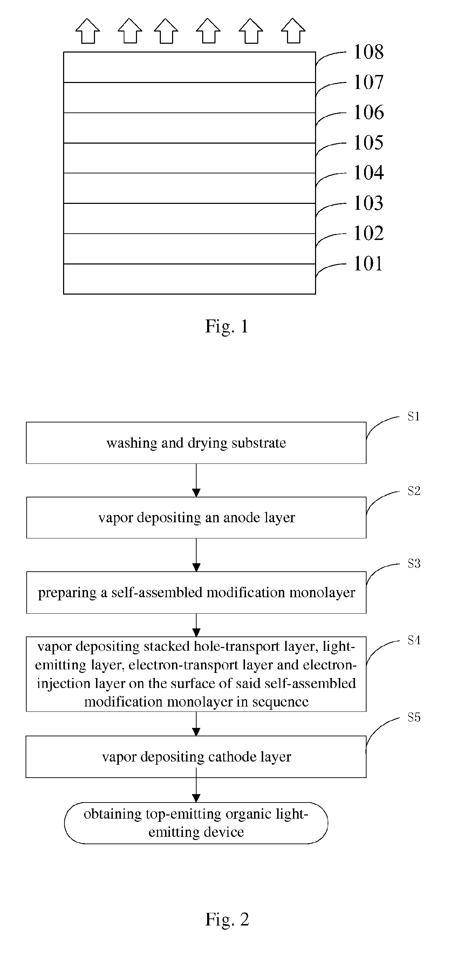

In one embodiment, as shown in Fig. 1, top-emitting organic light-emitting device comprises, stacked in sequence, a substrate (101), an anode layer (102), a self-assembled modification monolayer (103), a hole-transport layer (104), a light-emitting layer (105), an electron-transport layer (106), an electron-injection layer (107) and a cathode layer (108); that is, substrate 101/anode layer 102/self-assembled modification monolayer 103/hole-transport layer 104/light-emitting layer 105/electron-transport layer 106/electron-injection layer 107/cathode layer 108.

In the top-emitting organic light-emitting device, material of the self-assembled modification monolayer 103 is alkanethiol, which has long chain and a general formula of CH₃(CH₂)ₙ-SH, wherein, 5≤n≤21. The self-assembled modification monolayer links to metallic film by chemical bonds via sulfhydryl group of thiol.

In the top-emitting organic light-emitting device, material of the substrate 101 is polymer thin film, such as polyethylene terephthalate (PET), polyether sulfone (PES), polyethylene naphthalate (PEN) or polycarbonate (PC). Given that the top-emitting organic light-emitting device is a top-emitting OLED device, so the substrate material which is polymer film must be subjected to flat and hardening treatment to achieve a surface hardness of up to 2H-3H (pencil hardness).

Material of hole-transport layer 104, light-emitting layer 105, electron-transport layer 106 and electron-injection layer 107 of the top-emitting organic light-emitting device is commonly used in the art, such as:

Material of hole-transport layer is selected from the group consisting of N,N'-di-[(1-naphthalenyl)-N,N'-diphenyl]- (1,1'-biphenyl)- 4,4'- diamine (NPB), N,N'-bis(3-methylphenyl)-N,N'-diphenyl-benzidine (TPD) and 1,1-bis[4-(N,N-di(p-tolyl)amino)phenyl]cyclohexane (TAPC);

Material of light-emitting layer is selected from N,N'-di-[(1-naphthalenyl)-N,N'-diphenyl]- (1,1'-biphenyl)- 4,4'- diamine (NPB) doped with bis(2-methyldibenzo[f,h]quinoxaline) (acetylacetonate) iridium (Ir(MDQ)₂(acac)), 4,4',4"-tris(carbazol-9-yl)-triphenylamine (TCTA) doped with tris(2-phenylpyridine)iridium (Ir(ppy)₃), tris(8-hydroxyquinolinato)aluminium (Alq₃) doped with 4-(dicyanomethylene)-2-tert-butyl-6-(1,1,7,7-tetramethyljulolidin-4-yl-vinyl)-4h-pyra n (DCJTB), and DPVBi; that is, materials of light-emitting layer are selected from NPB:Ir(MDQ)₂(acac) (wherein, NPB is host material, Ir(MDQ)₂(acac) is guest material, doping mass percentage of the guest material is 5%), TCTA:Ir(ppy)₃ (wherein, TCTA is host material, Ir(ppy)₃ is guest material, doping mass percentage of the guest material is 3%), Alq₃: DCJTB (wherein, Alq₃ is host material, DCJTB is guest material, doping mass percentage of the guest material is 2%) and DPVBi.

Material of electron-transport layer is selected from the group consisting of tris(8-hydroxyquinolinato)aluminium (Alq₃), 4,7-diphenyl-1,10-phenanthroline (Bphen) and 1,3,5-tris(1-phenyl-1H-benzimidazol-2-yl)benzene (TPBi);

Material of electron-injection layer is selected from the group consisting of LiF, CsF and Li₂O.

Material of said anode layer is selected from metal Ag, Al and Au. Thickness of said anode layer is in the range of 18-100 nm.

Cathode layer of the top-emitting organic light-emitting device is one monolayer or two monolayers; material of said cathode layer is aluminium (Al), silver (Ag), samarium (Sm) or ytterbium (Yb); the cathode layer is semitransparent cathode, the total thickness is in the range of 18-30 nm; visible transmittance of the cathode layer is in the range of 55%-75%.

The present invention also provides a method for preparing top-emitting organic light-emitting device as shown in Fig. 2, which comprises the following steps:

S1. placing substrate (e.g. polymer film) into deionized water containing detergent for ultrasonic cleaning, washing with deionized water, ultrasonically treating successively with isopropanol and acetone, then blow drying with nitrogen for later use; wherein, polymer film comprises polyethylene terephthalate (PET), polyether sulfone (PES), polyethylene naphthalate (PEN) and polycarbonate (PC);

S2, vapor depositing an anode layer on the surface of the cleaned substrate by vacuum coating method, thickness of the anode layer is in the range of 18-100 nm;

S3, preparing a self-assembled modification monolayer on the surface of said anode layer; wherein, material of the self-assembled modification monolayer is alkanethiol having a general formula of CH₃(CH₂)n-SH, 5≤n≤21;

S4, vapor depositing stacked hole-transport layer, light-emitting layer, electron-transport layer and electron-injection layer on the surface of anode layer in sequence by vacuum coating method; thicknesses of said hole-transport layer, light-emitting layer, electron-transport layer and electron-injection layer are in the range of, in order, 50-60 nm, 15-20 nm, 30-40 nm and 1 nm.

S5, vapor depositing cathode layer of 18-30 nm thick on the surface of said electron-injection layer;

After the above process, top-emitting organic light-emitting device is obtained.

In order to improve adsorption capacity of self-assembled monolayer on anode layer, step S2 of the method for preparing top-emitting organic light-emitting device further comprises the following steps:

Placing the prepared anode layer into plasma processor, vacuumizing to 10-60 Pa, discharging at high-frequency in air atmosphere, glow discharge treating under the conditions of RF power 60W for 5-15 minutes, and cleaning the surface of anode layer with plasma

By such plasma treatment, the surface energy of the anode layer is improved, thereby improving the uniformity and compactness of the self-assembled monolayer on the surface of the anode layer.

The step S3 further comprises:

S31. dissolving alkanethiol having a general formula of CH₃(CH₂)n-SH into ethanol or diethyl ether to prepare solution, the molar concentration of the solution can be in the range of 0.1-10 mM (i.e. mmol/L);

S32. immersing the substrate on which the anode layer has been deposited into said solution, immersing for 5-30 min, taking out and drying with nitrogen flow, then obtaining the self-assembled modification monolayer on the surface of anode layer.

The top-emitting organic electroluminescence device provided in the present invention comprises a self-assembled modification monolayer, deposited on the surface of anode layer, the self-assembled modification monolayer is alkanethiol having a general formula of CH₃(CH₂)n-SH. Utilizing the self-assembled modification monolayer, the work-function of the anode layer is increased, the hole-injection barrier between the anode layer and the hole-transport layer is reduced, the start-voltage of the OLED is decreased, thus improving the luminous efficiency of the OLED.

Further description of the present invention will be illustrated, which combined with preferred embodiments and the drawings.

### Example 1

The top-emitting organic light-emitting device of the Example 1 has a structure of PET/Al/ CH₃(CH₂)₅-SH /α-NPD/NPB:Ir(MDQ)₂(acac)/ Alq₃/LiF/ Ag.

The method for preparing the top-emitting organic light-emitting device is as follows.

PET film having a thickness of 0.175mm was placed into deionized water containing detergent for ultrasonic cleaning, ultrasonically treated successively with isopropanol and acetone, then blow dried with nitrogen. Al film of 60 nm thick is formed on the surface of PET film by vacuum thermal coating method to prepare flexible anode.

The anode was placed into plasma processor, evacuated to 10 Pa, and then discharging at high frequency. Glow discharge was created under the conditions of RF power 60W, the anode was treated for 30 minutes; 1-hexanethiol (CH₃(CH₂)₅-SH) was dissolved in ethanol, concentration was 10 mM. Thereafter, the plasma-treated Al anode was immersed in the solution for 30 minutes to make 1-hexanethiol adsorbed on the surface of the Al film. A self-assembled film was formed, and then took out for drying with nitrogen.

After drying, the following layers were formed in sequence on the Al film modified with the above self-assembled monolayer by vacuum thermal deposition method: hole-transport layer of NPB having a thickness of 50 nm, light-emitting layer of NPB:Ir(MDQ)₂(acac) (wherein NPB was host material, Ir(MDQ)₂(acac) was guest material, doping mass percentage of the guest material was 5%) having a thickness of 20 nm, electron-transport layer of Alq₃ having a thickness of 40 nm, electron-injection layer of LiF having a thickness of 1 nm, and Ag layer having a thickness of 18 nm.

### Example 2

The top-emitting organic light-emitting device of the Example 2 has a structure of PES/Ag/ CH₃(CH₂)₁₁-SH /NPB/ TCTA:Ir(ppy)₃/ Bphen/LiF/ (Al/Sm).

The method for preparing the top-emitting organic light-emitting device is as follows.

PES film having a thickness of 0.15mm was placed into deionized water containing detergent for ultrasonic cleaning, ultrasonically treated successively with isopropanol and acetone, then blow dried with nitrogen. Ag film of 80 nm thick is formed on the surface of flexible substrate by vacuum thermal coating method to prepare flexible anode.

The anode was placed into plasma processor, evacuated to 40 Pa, and then discharging at high frequency. Glow discharge was created under the conditions of RF power 60W, the anode was treated for 10 minutes; 1-dodecanethiol (CH₃(CH₂)₁₁-SH) was dissolved in ethanol, concentration was 1 mM. Thereafter, the plasma-treated Ag anode was immersed in the solution for 15 minutes. A self-assembled film was formed, and then took out for drying with nitrogen.

After drying, the following layers were formed in sequence on the metal Ag film modified with the above self-assembled monolayer by vacuum thermal deposition method: hole-transport layer of NPB having a thickness of 60 nm, light-emitting layer of TCTA:Ir(ppy)₃ (wherein TCTA was host material, Ir(ppy)₃ was guest material, doping mass percentage of the guest material was 3%) having a thickness of 15 nm, electron-transport layer of Bphen having a thickness of 30 nm, electron-injection layer of LiF having a thickness of 1 nm, and cathode layer having a structure of Al(1nm thick)/Sm(30 nm thick). The cathode layer had two monolayers.

### Example 3

The top-emitting organic light-emitting device of the Example 3 has a structure of PC/Au/ CH₃(CH₂)₁₇-SH /TAPC/DPVBi/ TPBi/CsF/Ag.

The method for preparing the top-emitting organic light-emitting device is as follows.

PC film having a thickness of 0.20mm was placed into deionized water containing detergent for ultrasonic cleaning, ultrasonically treated successively with isopropanol and acetone, then blow dried with nitrogen. Au film of 60 nm thick is formed on the surface of flexible substrate by vacuum thermal coating method to prepare flexible anode.

The anode was placed into plasma processor, evacuated to 60 Pa, and then discharging at high frequency. Glow discharge was created under the conditions of RF power 60W, the anode was treated for 10 minutes; n-octadecyl mercaptan (CH₃(CH₂)₁₇-SH) was dissolved in ethanol, concentration was 0.5 mM. Thereafter, plasma-treated Au anode was immersed in the solution for 30 minutes. A self-assembled film was formed, and then took out for drying with nitrogen.

After drying, the following layers were formed in sequence on the Au film modified with the above self-assembled monolayer by deposition method: hole-transport layer of TAPC having a thickness of 50 nm, light-emitting layer of DPVBi having a thickness of 20 nm, electron-transport layer of TPBi having a thickness of 40 nm, electron-injection layer of CsF having a thickness of 1 nm, and Ag layer having a thickness of 20 nm.

### Example 4

The top-emitting organic light-emitting device of the Example 4 has a structure of PEN/Al/ CH₃(CH₂)₂₁-SH /TPD/Alq₃:DCJTB / Alq₃/Li₂O/(Yb/Ag).

The method for preparing the top-emitting organic light-emitting device is as follows.

PEN film having a thickness of 0.18mm was placed into deionized water containing detergent for ultrasonic cleaning, ultrasonically treated successively with isopropanol and acetone, then blow dried with nitrogen. Al film of 100 nm thick is formed on the surface of flexible substrate by vacuum thermal coating method to prepare anode.

The anode was placed into plasma processor, evacuated to 50 Pa, and then discharging at high frequency. Glow discharge was created under the conditions of RF power 60W, the anode was treated for 15 minutes; 1-docosanethiol (CH₃(CH₂)₂₁-SH) was dissolved in diethyl ether, concentration was 0.1 mM. Thereafter, the plasma-treated Al anode was immersed in the solution for 5 minutes, and then took out for drying with nitrogen.

After drying, the following layers were formed in sequence on the Al film modified with the above self-assembled monolayer by deposition method: hole-transport layer of TPD having a thickness of 50 nm, light-emitting layer of Alq₃: DCJTB (wherein Alq₃ was host material, DCJTB was guest material, doping mass percentage of the guest material was 2%) having a thickness of 20 nm, electron-transport layer of Alq₃ having a thickness of 35 nm, electron-injection layer of Li₂O having a thickness of 1 nm, and cathode layer of two stacked monolayers having a structure of Yb(10 nm thick)/Ag(12 nm thick).

### Comparative Example 1

The organic light-emitting device of the Comparative Example 1 has a structure of PES/Ag/NPB/ TCTA:Ir(ppy)₃/ Bphen/LiF/ (Al/Sm).

The method for preparing the organic light-emitting device is as follows.

PES film having a thickness of 0.15mm was placed into deionized water containing detergent for ultrasonic cleaning, ultrasonically treated successively with isopropanol and acetone, then blow dried with nitrogen. Ag film of 80 nm thick is formed on the surface of flexible substrate by vacuum thermal coating method to prepare flexible anode.

The following layers were formed in sequence on the metal Ag film by vacuum thermal deposition method: hole-transport layer of NPB having a thickness of 60 nm, light-emitting layer of TCTA:Ir(ppy)₃ (wherein TCTA was host material, Ir(ppy)₃ was guest material, doping mass percentage of the guest material was 3%) having a thickness of 15 nm, electron-transport layer of Bphen having a thickness of 30 nm, electron-injection layer of LiF having a thickness of 1 nm, and cathode layer of two monolayers having a structure of Al(1nm thick)/Sm(30 nm thick).

Luminous properties of the devices prepared in Examples 1, 2, 3, 4 and Comparative Example 1 were tested, results were shown in Table. 1.

**Table. 1**

| | Start-voltage (V) | Luminance at 9V (cd/cm²) | Current Efficiency (cd/A) |
|---|---|---|---|
| Example 1 | 3.8 | 2551 | 12.5 |
| Example 2 | 3.3 | 3258 | 18.7 |
| Example 3 | 3.1 | 2214 | 13.9 |
| Example 4 | 3.5 | 3112 | 14.5 |
| Comparative Example 1 | 4.4 | 1947 | 10.4 |

The results show that the start-voltage of the top-emitting organic light-emitting device made of an anode with self-assembled modification monolayer is obviously lower than that of the top-emitting organic light-emitting device made of an anode without self-assembled modification monolayer; it is because that hole-injection barrier between the anode and the hole-transport material can be reduced after the modification of anode metal thin film by self-assembled modification monolayer, the start-voltage is thereby reduced.

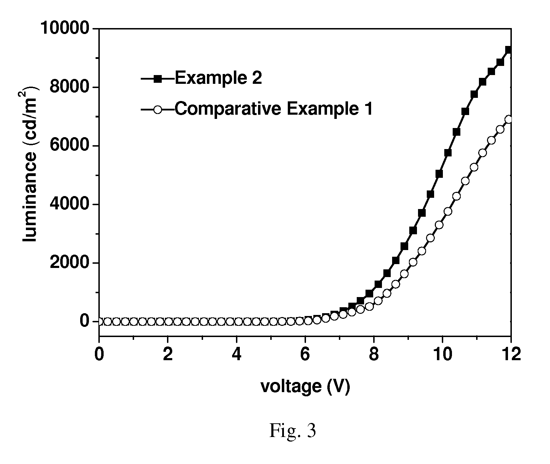

Fig. 3 shows voltage-luminance curves of the top-emitting organic light-emitting devices prepared in Example 2 and Comparative Example 1. As can be seen from Fig. 3, the luminance of the top-emitting organic light-emitting device made of an anode with self-assembled modification monolayer is greater than that of the top-emitting organic light-emitting device made of an anode without self-assembled modification monolayer; also, the current efficiency of the top-emitting organic light-emitting device made of an anode with self-assembled modification monolayer is greater than that of the top-emitting organic light-emitting device made of an anode without self-assembled modification monolayer.

While the present invention has been described with reference to particular embodiments, it will be understood that the embodiments are illustrative and that the invention scope is not so limited. Alternative embodiments of the present invention will become apparent to those having ordinary skill in the art to which the present invention pertains. Such alternate embodiments are considered to be encompassed within the spirit and scope of the present invention. Accordingly, the scope of the present invention is described by the appended claims and is supported by the foregoing description.

## Claims

1. A top-emitting organic light-emitting device, wherein comprising a substrate, an anode layer, a self-assembled modification monolayer, a hole-transport layer, a light-emitting layer, an electron-transport layer, an electron-injection layer and a cathode layer stacked in sequence.

2. The top-emitting organic light-emitting device according to claim 1, wherein material of said self-assembled modification monolayer is alkanethiol having a general formula of CH₃(CH₂)ₙ-SH, 5≤n≤21.

3. The top-emitting organic light-emitting device according to claim 1, wherein said cathode layer is one monolayer of one material or two stacked monolayers of different material; material of said cathode layer is aluminium, silver, samarium or ytterbium.

4. The top-emitting organic light-emitting device according to claim 1, wherein material of said substrate is polyethylene terephthalate, polyether sulfone, polyethylene naphthalate or polycarbonate; material of said anode layer is silver, aluminium or gold.

5. A method for preparing top-emitting organic light-emitting device, comprising:
S1, washing and drying substrate;
S2, vapor depositing an anode layer on the surface of said substrate;
S3, preparing a self-assembled modification monolayer on the surface of said anode layer;
S4, vapor depositing stacked hole-transport layer, light-emitting layer, electron-transport layer and electron-injection layer on the surface of said self-assembled modification monolayer in sequence;
S5, vapor depositing cathode layer on the surface of said electron-injection layer, obtaining said top-emitting organic light-emitting device.

6. The method for preparing top-emitting organic light-emitting device according to claim 5, wherein said S2 further comprises the steps of:
placing the prepared anode layer into plasma processor, and cleaning the surface of anode layer with high-frequency glow discharge plasma under conditions of vacuum and in air atmosphere.

7. The method for preparing top-emitting organic light-emitting device according to claim 5, wherein material of said self-assembled modification monolayer is alkanethiol having a general formula of CH₃(CH₂)ₙ-SH, 5≤n≤21.

8. The method for preparing top-emitting organic light-emitting device according to claim 7, wherein said S3 further comprises the steps of:
S31. dissolving alkanethiol having a general formula of CH₃(CH₂)ₙ-SH into ethanol or diethyl ether to prepare solution of molar concentration of 0.1-10 mM;
S32. immersing the substrate with deposited anode layer into said solution, immersing for 5-30 min, taking out and drying with nitrogen flow, then obtaining the self-assembled modification monolayer on the surface of anode layer.

9. The top-emitting organic light-emitting device according to claim 5, wherein said cathode layer is one monolayer of one material or two stacked monolayers of different material; material of said cathode layer is aluminium, silver, samarium or ytterbium.

10. The method for preparing top-emitting organic light-emitting device according to claim 5, wherein material of said substrate is polyethylene terephthalate, polyether sulfone, polyethylene naphthalate or polycarbonate; material of said anode layer is silver, aluminium or gold.
